# EUROPEAN PATENT APPLICATION

(11) **EP 4 722 411 A1**
(43) Date of publication of application: **08.04.2026**
(21) Application number: 25204023.3
(22) Date of filing: 23.09.2025
(51) Int. Cl.: C23C 16/44, C23C 16/448, C23C 16/455

(54) **A SEMICONDUCTOR MANUFACTURING APPARATUS AND A METHOD FOR MANUFACTURING OF A SEMICONDUCTOR**

(30) Priority: 26.09.2024 US 202463699729 P
(71) Applicant: ASM IP Holding B.V., 1322 AP Almere (NL)
(72) Inventor: DE JONGE, Jeroen, 1322 AP Almere (NL)
(74) Representative: V.O.

(57) **Abstract**

An apparatus and method is disclosed. The apparatus having: a reaction chamber; one or more gas inlets connected to said reaction chamber to provide precursor gas into said reaction chamber; and; an accumulator connected to at least one of said one or more gas inlets. The apparatus having three evaporators/condensers, a first evaporator/condenser connectable with the accumulator and constructed to be heated to provide sublimated/evaporated precursor to the reaction chamber via the accumulator; a second evaporator/condenser connectable to a bulk precursor storage constructed to be cooled to deposit precursor from the heated storage in it; and a third evaporator/condenser connectable between an exhaust of the reaction chamber and a pump and to be constructed to be cooled to deposit precursor from the exhaust before it reaches the pump.

## Description

### FIELD OF INVENTION

The present disclosure relates generally to a semiconductor manufacturing apparatus and method for manufacturing of a semiconductor. The present disclosure more specifically relates to re-using semiconductor precursor gas.

### BACKGROUND OF THE DISCLOSURE

Semiconductor fabrication processes for forming semiconductor device structures, such as, for example, transistors, memory elements, and integrated circuits, are wide ranging and may include deposition processes.

The deposition processes may comprise flowing a precursor gas over the substrate resulting in layers being deposited on a of substrate. During the deposition processes, the excess precursor that is not reacting with the substrate may be exhausted to a pump. The precursor may be very valuable and exhausting it via the pump may be an environmental waste.

Accordingly, there may be a need to re-use precursor gas exhausted to the pump in a semiconductor manufacturing apparatus.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

In at least one embodiment of the invention, a semiconductor manufacturing apparatus is disclosed, the apparatus comprising:
a reaction chamber;
one or more gas inlets connected to said reaction chamber to provide precursor gas into said reaction chamber; and;
an accumulator connected to at least one of said one or more gas inlets. The apparatus may comprise three evaporators/condensers. A first evaporator/condenser may be connectable with the accumulator and constructed to be heated to provide evaporated precursor to the reaction chamber via the accumulator. A second evaporator/condenser may be connectable to a bulk precursor storage and may be constructed to be cooled to deposit precursor from the heated storage in it. A third evaporator/condenser may be connectable between an exhaust of the reaction chamber and a pump and may be constructed to be cooled to deposit precursor from the exhaust before it reaches the pump. Any precursor gas remaining in the exhaust gas may be deposited inside the third evaporator/condenser. In this way the gas lead to the pump may be more clean which is an environmental advantage. The expensive precursor that is reclaimed in the third evaporator/condenser may be re-used in this sense may lower the operational cost of the apparatus. Simultaneously the second evaporator/condenser may be re-filled so that the apparatus may have a evaporator/condenser ready for usage at all time.

In at least an embodiment of the invention a method for manufacturing of a semiconductor with a semiconductor manufacturing apparatus may be disclosed. The apparatus may comprise: a reaction chamber for loading a substrate: one or more gas inlets connected to said reaction chamber to provide precursor gas into said reaction chamber to deposit a layer on the substrate; and; an accumulator connected to at least one of said one or more gas inlets. The method may comprise: connecting a first evaporator/condenser with the accumulator and heating the first evaporator/condenser to provide evaporated precursor to the reaction chamber via the accumulator; connecting a second evaporator/condenser to a bulk precursor storage and heating the bulk precursor storage while cooling the second evaporator/condenser to deposit precursor from the storage in the second evaporator/condenser; and, connecting a third evaporator/condenser between an exhaust of the reaction chamber and a pump and cooling the third evaporator/condenser to deposit precursor from the exhaust in the third evaporator/condenser before it reaches the pump.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

### BRIEF DESCRIPTION OF THE DRAWING FIGURES

While the specification concludes with claims particularly pointing out and distinctly claiming what are regarded as embodiments of the invention, the advantages of embodiments of the disclosure may be more readily ascertained from the description of certain examples of the embodiments of the disclosure when read in conjunction with the accompanying drawings, in which:

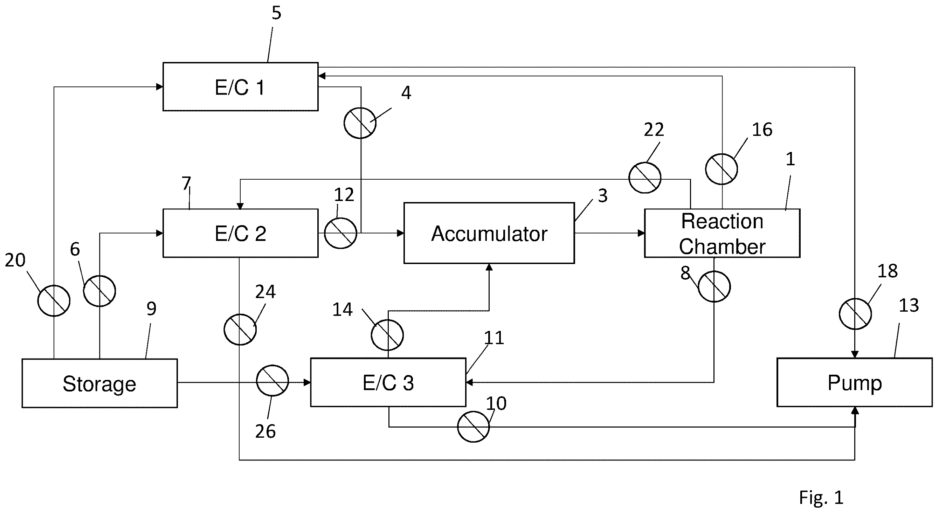

FIG. 1 illustrates a cross-sectional schematic diagram of a layer deposition system according to the embodiments of the disclosure.

The illustrations presented herein are not meant to be actual views of any particular material, structure, or device, but are merely idealized representations that are used to describe embodiments of the disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

As used herein, the term "substrate" may refer to any underlying material or materials that may be used, or upon which, a device, a circuit, or a layer may be formed.

As used herein, the term "cyclical chemical vapor deposition" may refer to any process wherein a substrate is sequentially exposed to one or more volatile precursors, which react and/or decompose on a substrate to produce a desired deposition.

As used herein, the term precursor may refer to a molybdenum halide precursor, such as a molybdenum chloride precursor, a molybdenum iodide precursor, or a molybdenum bromide precursor; or a molybdenum chalcogenide, such as a molybdenum oxychloride, a molybdenum oxyiodide, a molybdenum (IV) dichloride dioxide (MoO₂Cl₂) precursor, or a molybdenum oxybromide.

As used herein, the term "atomic layer deposition" (ALD) may refer to a vapor deposition process in which deposition cycles, preferably a plurality of consecutive deposition cycles, are conducted in a reaction chamber. Typically, during each cycle the precursor is chemisorbed to a deposition surface (e.g., a substrate surface or a previously deposited underlying surface such as material from a previous ALD cycle), forming a monolayer or sub-monolayer that does not readily react with additional precursor (i.e., a self-limiting reaction). Thereafter, if necessary, a reactant (e.g., another precursor or reaction gas) may subsequently be introduced into the process chamber for use in converting the chemisorbed precursor to the desired material on the deposition surface. Typically, this reactant is capable of further reaction with the precursor. Further, purging steps may also be utilized during each cycle to remove excess precursor from the process chamber and/or remove excess reactant and/or reaction byproducts from the process chamber after conversion of the chemisorbed precursor. Further, the term "atomic layer deposition," as used herein, is also meant to include processes designated by related terms such as, "chemical vapor atomic layer deposition", "atomic layer epitaxy" (ALE), molecular beam epitaxy (MBE), gas source MBE, or organometallic MBE, and chemical beam epitaxy when performed with alternating pulses of precursor composition(s), reactive gas, and purge (e.g., inert carrier) gas.

As used herein, the term "layer" and "thin layer" may refer to any continuous or non-continuous structures and material formed by the methods disclosed herein. For example, "layer" and "thin layer" could include 2D materials, nanolaminates, nanorods, nanotubes, or nanoparticles, or even partial or full molecular layers, or partial or full atomic layers or clusters of atoms and/or molecules. "Layer" and "thin layer" may comprise material or a layer with pinholes, but still be at least partially continuous.

A number of example materials are given throughout the embodiments of the current disclosure, it should be noted that the chemical formulas given for each of the materials should not be construed as limiting and that the non-limiting example materials given should not be limited by a given example stoichiometry.

The present disclosure includes a semiconductor manufacturing apparatus that may perform a molybdenum layer deposition process. Molybdenum thin layers may be utilized in a number of applications, such as, for example, low electrical resistivity gap-fill, liner layers for 3D-NAND, DRAM word-line features, metal gate, DRAM top electrode, memory, or as an interconnect material in CMOS logic applications.

FIG. 1 illustrates a semiconductor manufacturing apparatus in accordance with at least one embodiment of the invention. The apparatus may comprise: a reaction chamber 1; one or more gas inlets connected to said reaction chamber to provide precursor gas into said reaction chamber; and; an accumulator 3 connected to at least one of said one or more gas inlets. The apparatus may comprise three evaporators/condensers, a first evaporator/condenser 5 connectable with the accumulator 3 and constructed to be heated to provide evaporated precursor to the reaction chamber 1 via the first valve 4 and accumulator 3. The first evaporator/condenser 5 may be heated between 50 to 200, preferably between 100 to 180°C to provide sublimated/evaporated precursor to the reaction chamber 1 via the accumulator. The temperature may be dependent on the pressure.

A second evaporator/condenser 7 may be connectable to a bulk precursor storage 9 via the second valve 6 and constructed to be cooled to deposit precursor from the heated bulk precursor storage 9 in it. The second evaporator/condenser 7 may be cooled/heated below 150, preferably below 130°C to deposit precursor in it. The temperature may be dependent on the pressure.

A third evaporator/condenser 11 connectable between an exhaust of the reaction chamber and a pump 13 via third and fourth valves 8, 10 and to be constructed to be cooled to deposit precursor from the exhaust before it reaches the pump 13. The third evaporator/condenser 11 may be cooled/heated below 150, preferably below 130°C to have any precursor gas remaining in the exhaust gas to be deposited inside the third evaporator/condenser. The temperature may be dependent on the pressure. In this way the gas lead to the pump may be more clean which is an environmental advantage. The expensive precursor that is reclaimed in the third evaporator/condenser may be re-used and in this sense may lower the operational cost of the apparatus. Simultaneously the second evaporator/condenser may be re-filled so that the apparatus may have a evaporator/condenser ready for usage at all time.

In an embodiment the semiconductor manufacturing apparatus may be constructed and arranged to switch between evaporators/condensers 5, 7, 11. For example, if one of the evaporators/condensers is empty. The apparatus may be provided with a controller operationally connected to the valves. The controller may be provided with a processor and a memory. The memory may be provided with a program to switch the function between the evaporators/condensers.

In an embodiment the second and/or third evaporators/condensers 7, 11 may be connected via fifth and sixth valves 12, 14 with the accumulator 3 and constructed to be heated to provide sublimated/evaporated precursor to the reaction chamber 1 via the accumulator. The later may be necessary when the first evaporator/condenser 5 is substantially empty and/or when the second and third evaporator/condenser are substantially full with precursor. The second evaporators/condensers 7 may be disconnected from the bulk precursor storage 9 by closing the second valve 6 and the third evaporator/condenser may be disconnected from the exhaust of the reaction chamber and the pump 13 by closing third and fourth valves 8, 10 at the same time. The first evaporator/condenser 5 may be disconnected from the accumulator 3 and the reaction chamber 1 by closing the first valve 4 simultaneously. The second and/or third evaporator/condenser 7, 11 may be heated between 50 to 200, preferably between 100 to 180°C to provide sublimated/evaporated precursor to the reaction chamber 1 via the accumulator. The temperature may be dependent on the pressure.

At the same time the first evaporator/condenser 5 may be connected between an exhaust of the reaction chamber 1 and a pump 13 via a seventh and eight valves 16, 18. The first evaporator/condenser may be constructed to be cooled to deposit precursor from the exhaust before it reaches the pump 13. The first evaporator/condenser 5 may be cooled/heated below 150, preferably below 130°C to have any precursor gas remaining in the exhaust gas to be deposited inside the first evaporator/condenser. The temperature may be dependent on the pressure. In this way the gas lead to the pump may be more clean which is an environmental advantage. The expensive precursor that is reclaimed in the first evaporator/condenser may be re-used to lower the operational cost of the apparatus.

In an embodiment the first evaporator/condenser 5 may also be connected to the bulk precursor storage 9 via a nineth valve 20 and constructed to be cooled/heated below 150, preferably below 130°C to deposit precursor from the heated bulk precursor storage 9 in it. This may be needed when the first evaporator/condenser is substantially empty.

When the second evaporator/condenser is empty the second evaporator/condenser may be connected between an exhaust of the reaction chamber and a pump via tenth and eleventh valves 22, 24. The second evaporator/condenser may be cooled/heated below 150, preferably below 130°C to deposit precursor from the exhaust before it reaches the pump 13 when the second evaporator/condenser 7 is substantially empty. The temperature may be dependent on the pressure. Any precursor gas remaining in the exhaust gas may be deposited inside the second evaporator/condenser. In this way the gas lead to the pump may be more clean which is an environmental advantage. The expensive precursor that is reclaimed in the second evaporator/condenser may be re-used to lower the operational cost of the apparatus.

In an embodiment, the second evaporator/condenser also may be connected to a bulk precursor storage via twelfth valve 26 and constructed to be cooled/heated below 150, preferably 130°C to deposit precursor from the heated storage in it when the second evaporator/condenser is substantially empty. This may for example be done after re-filling it from the exhaust to increase the filling rate.

In an embodiment, a method for manufacturing of a semiconductor with a semiconductor manufacturing apparatus is disclosed. The apparatus comprising:
a reaction chamber 1 for loading a substrate;
one or more gas inlets connected to said reaction chamber to provide precursor gas into said reaction chamber to deposit a layer on the substrate; and,
an accumulator 3 connected to at least one of said one or more gas inlets. The method comprising:
   connecting a first evaporator/condenser 5 with the accumulator 3 and heating the first evaporator/condenser 5 to provide evaporated precursor to the reaction chamber via the accumulator;
   connecting a second evaporator/condenser 7 to a bulk precursor storage 9 and heating the bulk precursor storage 9 while cooling the second evaporator/condenser 7 to deposit precursor from the bulk precursor storage 9 in the second evaporator/condenser 7; and,
   connecting a third evaporator/condenser 11 between an exhaust of the reaction chamber 1 and a pump 13 and cooling the third evaporator/condenser to deposit precursor from the exhaust in the third evaporator/condenser 11 before it reaches the pump 13.

In an embodiment, the method comprises switching between evaporators/condensers when the evaporators/condensers may be empty, for example.

In an embodiment said precursor gas comprises a vaporized liquid or solid precursor compound comprising a metal or a metalloid, said metal being selected from an alkaline metal, an alkaline earth metal, a transition metal, and a rare earth metal. The precursor compound may be a homoleptic or heteroleptic precursor.

In an embodiment the precursor compound may include at least one compound chosen from Titanium tetrachloride (TiCl₄), Vanadium tetrachloride (VCl₄), Molybdenum pentachloride (MoCl₅), Molybdenumdioxidichloride (MoO₂Cl₂), Niobiumpentachloride (NbCl₅), Tantalumpentachloride (TaCl₅), Aluminumtrichloride (AlCl₃), Hafniumtetrachloride (HfCl₄), Zirconiumtetrachloride (ZrCl₄), Tetrakis(ethylmethylamido)zirconium (TEMAZr) or Tetrakis(ethylmethylamido)hafnium (TEMAHf), Trimethylborate (TMB), Fluorotriethoxysilane (FTES), Tetrakis-dimethylamino Titanium (TDMAT), Tetrakis-diethylamino (TDEAT), CuTMVS, Diethylsilane, and Triethylphosphate (TEPO).

The example embodiments of the disclosure described above do not limit the scope of the invention, since these embodiments are merely examples of the embodiments of the invention, which is defined by the appended claims and their legal equivalents. Any equivalent embodiments are intended to be within the scope of this invention. Indeed, various modifications of the disclosure, in addition to those shown and described herein, such as alternative useful combination of the elements described, may become apparent to those skilled in the art from the description. Such modifications and embodiments are also intended to fall within the scope of the appended claims.

## Claims

1. A semiconductor manufacturing apparatus, the apparatus comprising:
a reaction chamber;
one or more gas inlets connected to said reaction chamber to provide precursor into said reaction chamber; and;
an accumulator connected to at least one of said one or more gas inlets;
wherein the apparatus comprises three evaporators/condensers, a first evaporator/condenser connectable with the accumulator and constructed to be heated to provide sublimated/evaporated precursor to the reaction chamber via the accumulator; a second evaporator/condenser connectable to a bulk precursor storage and constructed to be cooled to deposit precursor in it from the bulk precursor storage when the storage is heated; and a third evaporator/condenser connectable between an exhaust of the reaction chamber and a pump and constructed to be cooled to deposit precursor from the exhaust before it reaches the pump.

2. The semiconductor manufacturing apparatus according to claim 1, wherein said apparatus is constructed and arranged to switch between evaporators/condensers.

3. The semiconductor manufacturing apparatus according to claim 1 or 2, wherein the second and/or third evaporators/condensers are connectable with the accumulator and constructed to be heated to provide sublimated/evaporated precursor to the reaction chamber via the accumulator when the first evaporator/condenser is substantially empty and/or the second and third evaporators/ condensers are substantially full with precursor.

4. The semiconductor manufacturing apparatus according to any one of claims 1-3, wherein the first evaporator/condenser is connectable between the exhaust of the reaction chamber and the pump and constructed to be cooled to deposit precursor from the exhaust before it reaches the pump when the first evaporator/condenser is substantially empty.

5. The semiconductor manufacturing apparatus according to any one of claims 1-4, wherein the first evaporator/condenser is connectable to the bulk precursor storage and constructed to be cooled to deposit precursor from a heated bulk precursor storage in it when the first evaporator/condenser is substantially empty.

6. The semiconductor manufacturing apparatus according to any one of claims 1-5, wherein the second evaporator/condenser is connectable between the exhaust of the reaction chamber and the pump and constructed to be cooled to deposit precursor from the exhaust before it reaches the pump when the second evaporator/condenser is substantially empty.

7. The semiconductor manufacturing apparatus according to any one of claims 1-6, wherein said second evaporator/condenser is connectable to the bulk precursor storage and constructed to be cooled to deposit precursor in it from the bulk precursor storage when the storage is heated when the second evaporator/condenser is substantially empty.

8. The semiconductor manufacturing apparatus according to any one of claims 1-7, wherein said first evaporator/condenser is connectable with the accumulator and constructed to be heated between 50 to 200, preferably between 100 to 180°C to provide evaporated precursor to the reaction chamber via the accumulator.

9. The semiconductor manufacturing apparatus according to any one of claims 1-8, wherein said second evaporator/condenser is connectable to the bulk precursor storage and is constructed to be cooled/heated below 150, preferably below 130°C to deposit precursor in it from the bulk precursor storage when the storage is heated.

10. The semiconductor manufacturing apparatus according to any one of claims 1-9, wherein said third evaporator/condenser is connectable between the exhaust of the reaction chamber and the pump and constructed to be cooled/heated below 150, preferably below 130°C to deposit precursor from the exhaust before it reaches the pump.

11. The semiconductor manufacturing apparatus according to any one of claims 1-10, wherein said precursor comprises a vaporized liquid or solid precursor compound comprising a metal or a metalloid.

12. The semiconductor manufacturing apparatus according to claim 11, wherein said metal is selected from an alkaline metal, an alkaline earth metal, a transition metal, and a rare earth metal.

13. The semiconductor manufacturing apparatus according to claim 11 or 12, wherein said precursor compound is a homoleptic or heteroleptic precursor.

14. The semiconductor manufacturing apparatus according to any one of claims 11-13, wherein said precursor compound includes at least one compound chosen from Titanium tetrachloride (TiCl₄), Vanadium tetrachloride (VCl₄), Molybdenum pentachloride (MoCl₅), Molybdenumdioxidichloride (MoO₂Cl₂), Niobiumpentachloride (NbCl₅), Tantalumpentachloride (TaCl₅), Aluminumtrichloride (AlCl₃), Hafniumtetrachloride (HfCl₄), Zirconiumtetrachloride (ZrCl₄), Tetrakis(ethylmethylamido)zirconium (TEMAZr) or Tetrakis(ethylmethylamido)hafnium (TEMAHf) Trimethylborate (TMB), Fluorotriethoxysilane (FTES), Tetrakis-dimethylamino Titanium (TDMAT), Tetrakis-diethylamino (TDEAT), CuTMVS, Diethylsilane, and Triethylphosphate (TEPO).

15. The semiconductor manufacturing apparatus according to any one of claims 1-14, wherein said semiconductor manufacturing apparatus is a vertical furnace and said reaction chamber is configured for receiving a batch of wafers accommodated in a wafer boat.

16. The semiconductor manufacturing apparatus according to claim 15, wherein said vertical furnace is configured for chemical vapor deposition (CVD) or atomic layer deposition (ALD).

17. A method for manufacturing of a semiconductor with a semiconductor manufacturing apparatus comprising:
a reaction chamber for loading a substrate;
one or more gas inlets connected to said reaction chamber to provide precursor into said reaction chamber to deposit a layer on the substrate;
an accumulator connected to at least one of said one or more gas inlets; the method comprising:
connecting a first evaporator/condenser with the accumulator and heating the first evaporator/condenser to provide evaporated precursor to the reaction chamber via the accumulator;
connecting a second evaporator/condenser to a bulk precursor storage and heating the bulk precursor storage while cooling the second evaporator/condenser to deposit precursor from the storage in the second evaporator/condenser; and,
connecting a third evaporator/condenser between an exhaust of the reaction chamber and a pump and cooling the third evaporator/condenser to deposit precursor from the exhaust in the third evaporator/condenser before it reaches the pump.

18. The method according to claim 17, wherein the method comprises switching between evaporators/condensers.

19. The method according to claim 17 or 18, wherein said precursor comprises a vaporized liquid or solid precursor compound comprising a metal or a metalloid, said metal being selected from an alkaline metal, an alkaline earth metal, a transition metal, and a rare earth metal.

20. The method according to any one of claims 17-19, wherein said precursor compound includes at least one compound chosen from Titanium tetrachloride (TiCl₄), Vanadium tetrachloride (VCl₄), Molybdenum pentachloride (MoCl₅), Molybdenumdioxidichloride (MoO₂Cl₂), Niobiumpentachloride (NbCl₅), Tantalumpentachloride (TaCl₅), Aluminumtrichloride (AlCl₃), Hafniumtetrachloride (HfCl₄), Zirconiumtetrachloride (ZrCl₄), Tetrakis(ethylmethylamido)zirconium (TEMAZr) or Tetrakis(ethylmethylamido)hafnium (TEMAHf), Trimethylborate (TMB), Fluorotriethoxysilane (FTES), Tetrakis-dimethylamino Titanium (TDMAT), Tetrakis-diethylamino (TDEAT), CuTMVS, Diethylsilane, and Triethylphosphate (TEPO).
